# EUROPEAN PATENT APPLICATION

(11) **EP 3 813 111 A1**
(43) Date of publication of application: **28.04.2021**
(21) Application number: 19075016.6
(22) Date of filing: 25.10.2019
(51) Int. Cl.: H01L 27/02, H02H 9/04, H03F 1/52, H03F 3/45

(54) **INTEGRATED RF-CIRCUIT WITH ESD PROTECTION AND ELECTRONIC DEVICE COMPRISING THE SAME**

(71) Applicant: arQana Technologies BVBA, 3001 Heverlee (BE)
(72) Inventor: Qunaj, Valdrin, 2900 Schoten (BE); Chan, Chung Kei Thomas, 807015 Singapore (SG); Reynaert, Patrick, 3370 Boutersem (BE)
(74) Representative: Viering, Jentschura & Partner mbB Patent- und Rechtsanwälte

(57) **Abstract**

Embodiments relate to an integrated RF-circuit with ESD protection including a substrate of a III/V semiconductor material and an RF-circuit. The RF-circuit includes RF-input and -output, and at least one transistor. The integrated RF-circuit includes at least one coupled structure formed on the substrate, including first and second sides galvanically separated from each other, and configured to convey an RF signal between a first connection terminal of the first side and a second terminal of the second side. The second terminal may be connected to the RF-input or the RF-output of the RF-circuit and may include a low impedance path to a voltage connector of the integrated RF-circuit for flow of electrostatic discharge. Embodiments relate to an electronic device including a communication module including an integrated RF-circuit. The electronic device may be a device selected from one of: a mobile phone, a satellite communication device, a radar device.

## Description

The present disclosure relates to an integrated RF-circuit with ESD protection and an electronic device comprising the integrated RF-circuit.

### FIELD OF THE TECHNOLOGY

Conventional circuits use pn or pin junction components for ESD protection, for example diodes, transistors, or thyristors. Such components may be implemented in the semiconductor technology used for the circuit, such as silicon CMOS, or may be mounted separately on the circuit. Both options introduce manufacturing complexity when ESD protection is added to the circuit.

Therefore, there is a need to provide for improved ESD protection for RF-circuits.

### SUMMARY

Various embodiments relate to an integrated RF-circuit with electrostatic discharge (ESD) protection including a substrate of a II/V semiconductor material and an RF-circuit formed on the substrate. The integrated RF-circuit includes an RF-input and an RF-output, and may include at least one transistor. The RF-circuit may include at least one coupled structure formed on the substrate, including a first side and a second side galvanically separated from each other, and configured to convey an RF signal between a first connection terminal of the first side and a second terminal of the second side. The second terminal may be connected to the RF-input or the RF-output of the RF-circuit. The first side may include a low impedance path to a voltage connector of the integrated RF circuit for flow of electrostatic discharge.

Various embodiments relate to an electronic device including a communication module including an integrated RF circuit. The electronic device may further include an antenna coupled to the RF-input or the RF-output of the RF-circuit. According to various embodiments, the electronic device may be a device selected from one of: a mobile phone, a satellite communication device, a radar device.

### BRIEF DESCRIPTION OF THE DRAWINGS

In the following description, various embodiments of the present disclosure are described with reference to the following drawings, in which:
- FIG. 1 shows a schematic illustration of an integrated RF-circuit 100 including coupled structures 1100 and 2100 coupled to an RF-circuit 1300;
- FIG. 2 shows a schematic illustration of a coupled structure 1100 coupling a terminal 1200 to an RF-circuit 1300;
- FIG. 3 shows a schematic illustration of a coupled structure 2100 coupling an RF-circuit 2400 to a terminal 2200;
- FIG. 4 shows a schematic illustration of an integrated RF-circuit 1000 wherein a terminal 1200 is coupled to a primary winding 1162 of the transformer 1101 at the first side of the coupled structure 1100, and the circuit-side winding 1170 at the second side is coupled to an RF-circuit 1300;
- FIG. 5 shows a schematic illustration of an integrated RF-circuit 2000 wherein a terminal 2200 is coupled to a secondary winding 2162 of the transformer 2101 at the first side of the coupled structure 2100, and the circuit-side winding 2170 at the second side to an RF-circuit 2400;
- FIG. 6 shows an exemplary layout of a transformer 2101 as coupled structure 2100 coupled to connection terminals on the first side and to the RF-circuit 2300 on the second side.
- FIG. 7 shows a schematic illustration of a transmission line coupled structure 3000 coupling an RF-circuit 3400 to an RF terminal (RFout) 3300;
- FIG. 8 shows a schematic illustration of a transmission line coupled structure 4000 coupling an RF terminal (RFin) 4300 to an RF-circuit 3400;
- FIG. 9 shows a schematic illustration of a transformer as coupled structure including an additional ESD protection for the first side, in the form of an ESD discharging connection between the ends of the primary winding; and
- FIG. 10 shows a schematic illustration of a transformer as coupled structure including an additional ESD protection for the first side, in the form of an ESD discharging connection between the ends of the secondary winding.

### DETAILED DESCRIPTION

The following detailed description describes specific details and embodiments in which the invention may be practiced. These embodiments are described in sufficient detail to enable those skilled in the art to practice the invention. Other embodiments may be utilized and changes may be made without departing from the scope of the invention. The various embodiments are not necessarily mutually exclusive, as some embodiments can be combined with one or more other embodiments to form new embodiments.

Features that are described in the context of an embodiment may correspondingly be applicable to the same or similar features in the other embodiments. Features that are described in the context of an embodiment may correspondingly be applicable to the other embodiments, even if not explicitly described in these other embodiments. Furthermore, additions and/or combinations and/or alternatives as described for a feature in the context of an embodiment may correspondingly be applicable to the same or similar feature in the other embodiments.

The invention illustratively described herein may suitably be practiced in the absence of any element or elements, limitation or limitations, not specifically disclosed herein. Thus, for example, the terms "comprising", "including," containing", etc. shall be read expansively and without limitation. The word "comprise" or variations such as "comprises" or "comprising" will accordingly be understood to imply the inclusion of a stated integer or groups of integers but not the exclusion of any other integer or group of integers. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by exemplary embodiments and optional features, modification and variation of the inventions embodied herein disclosed may be resorted to by those skilled in the art, and that such modifications and variations are considered to be within the scope of this invention.

A substrate, according to various embodiments, may mean a substrate of a IIIN semiconductor material, for example GaAs or InP. An RF-circuit and at least one coupled structure formed on the substrate may mean that the RF-circuit is formed via semiconductor formation processes (e.g. layer deposition and etching) on the substrate and the substrate and the RF-circuit form a single die, thus, without having any other die or die-substrate in between. Likewise, the at least one coupled structure formed on the substrate may mean that the coupled structure(s) is formed via semiconductor formation processes (e.g. layer deposition and etching) on the substrate and the substrate and the coupled structure(s) a single die, thus, without having any other die or die-substrate in between.

According to various embodiments, the first side may include an additional low impedance path to the voltage connector or to an additional voltage connector of the integrated RF circuit for flow of electrostatic discharge.

According to various embodiments, a connection to ground, may refer to a connection to a supply voltage potential, which is treated as the reference supply voltage potential of a circuit, e.g. of the integrated RF circuit; in particular, a connection to ground, may refer to a connection to the voltage connector, which is for the connection to the supply voltage potential treated as ground.

According to various embodiments, a connection or a path to a voltage connector of the integrated RF circuit may be of low impedance. For example a "low impedance path to ground" may refer to an electrical connection to the voltage connector which is electrically connected with the supply voltage potential treated as ground potential for the integrated RF circuit, for example an on-chip DC-ground. Thus, the path may be an electrically conductive path configured to allow flow of electrostatic discharge. The expression "low impedance path" may mean an electrically conductive path including impedance sufficiently small for discharge of an ESD event, without causing noteworthy power loss in the path. For example, the impedance of the low impedance path may be lower, e.g. substantially lower, than an impedance between the first side and the second side of the coupled structure, for example, when determined at a same frequency outside of a pre-defined operating frequency band of the integrated RF-circuit. The term low impedance may also include the meaning of low resistance, for example lower than 0.1 ohms. Given the present disclosure, the skilled person in the art would understand the meaning of a low impedance. According to some embodiments, the coupled structure may be a transformer coupled structure, including a transformer. The at least one coupled structure may be a transformer with a primary winding on the first side and a circuit-side winding on the second side. The first side may be an input side of the at least one coupled structure. An output of the circuit-side winding may be coupled to the RF-input of the RF-circuit. A transformer, of a transformer coupled structure in according to various embodiments, may also interact with the RF-circuit, since it resonates with the input and output impedance of the circuit in order to minimize the losses. The coupled structure according to various embodiments finds advantageous use in power stage of RF-amplifiers, for example in a power-stage of a multi-stage amplifier, wherein losses must be minimized as much as possible.

As used herein and in accordance with various embodiments, the expression term "coupled to" may mean an RF-signal coupling. Coupling may include the meaning of connection. For example a terminal of a transistor may be coupled, for example connected, to a terminal of a transformer.

According to some embodiments, the at least one transistor may include a first transistor electrically connected with an end of the circuit-side winding of the transformer. The first transistor may include a II/V semiconductor structure, for example the first transistor may be a FET transistor including a channel of a II/V semiconductor, e.g., of GaAs or InP.

According to some embodiments, the RF-circuit may include a differential amplifier including the first transistor and a second transistor. A respective control terminal of the first and second transistors may constitute the RF-input and a further RF-input, each coupled to a corresponding end of the circuit-side winding of the transformer. Examples of transistor(s) are field effect transistor FET(s). For a FET, an exemplary control terminal is a gate. Exemplary controlled terminals of a FET are source and drain which may be controlled via the gate.

According to some embodiments, the circuit-side winding and the primary winding may be formed as at least partially parallel conductors. Each of the conductors may be disposed in a respective metal pattern layer. The conductors may be ring shaped, for example, partially ring shaped. For example, the circuit-side winding and the primary winding may be formed of stacked layers of conductors separated by a dielectric layer. Exemplary conductors may be selected from: copper, gold, alloys of copper, alloys of gold.

According to some embodiments, the circuit-side winding of the transformer may further include a biasing connection between the ends of the circuit-side winding, for example at about the middle between the ends of the circuit-side winding, which may also be named herein as center tap. The biasing connection may be coupled to a voltage connector of the integrated RF circuit, for example VDD.

According to various embodiments, the transformer may have a self-resonant frequency which may be smaller than an operating frequency of a signal at the RF-input of the RF-circuit. Thus, the transformer may work above the self-resonant frequency.

According to some embodiments, the at least one coupled structure may be a transformer with a secondary winding on the first side and a circuit-side winding on the second side. The first side may be an output side of the at least one coupled structure. An input of the circuit-side winding may be coupled to the RF-output of the RF-circuit.

According to some embodiments, the at least one transistor may include a first transistor electrically connected with an end of the circuit-side winding of the transformer. The first transistor may include a II/V semiconductor structure, for example the first transistor may be a FET transistor including a channel of a II/V semiconductor, e.g., of GaAs or InP.

According to some embodiments, the RF-circuit may include a differential amplifier including the first transistor and a second transistor. RF signal may be input at respective control terminals of the first and second transistors. Respective controlled terminals of the first and second transistors may constitute the RF-output and a further RF-output, each coupled to a corresponding end of the circuit-side winding of the transformer. Examples of transistor(s) are field effect transistor FET(s). For a FET, an exemplary control terminal is a gate. Exemplary controlled terminals of a FET are source and drain which may be controlled via the gate.

According to some embodiments, the circuit-side winding and the secondary winding are formed as at least partially parallel conductors. Each of the conductors may be disposed in a respective metal pattern layer. The conductors may be ring shaped, for example, partially ring shaped. For example, the circuit-side winding and the secondary winding may be formed of stacked layers of conductors separated by a dielectric layer. Exemplary conductors may be selected from: copper, gold, alloys of copper, alloys of gold.

According to various embodiments, the circuit-side winding of the transformer may further include a biasing connection between the ends of the circuit-side winding, for example at about the middle between the ends of the circuit-side winding, which may also be named herein as center tap. The biasing connection may be coupled, e.g. via a bias line, to a voltage connector of the integrated RF-circuit, for example VDD. Decoupling capacitor(s) may also be provided for the bias line.

According to various embodiments, the transformer may have a self-resonant frequency smaller than an operating frequency of a signal at the RF-output of the RF-circuit. Thus, the transformer would work above the self-resonant frequency.

According to various embodiments, the first side may be an input side of the at least one coupled structure. The at least one coupled structure may be a transmission line coupled structure.

According to various embodiments, the transmission line coupled structure may include a first quarter wave coupler and a second quarter wave coupler. The first quarter wave coupler may include a first direct transmission line and a first coupled transmission line. An output port of the first coupled transmission line may be coupled to the RF-input of the RF-circuit.

According to various embodiments, the transmission line coupled structure has a self-resonant frequency smaller than an operating frequency of a signal at the RF-input of the RF-circuit.

According to various embodiments, the first side may be an output side of the at least one coupled structure. The at least one coupled structure may be a transmission line coupled structure.

According to various embodiments, the transmission line coupled structure may include a first quarter wave coupler and a second quarter wave coupler. The first quarter wave coupler may include a first direct transmission line and a first coupled transmission line. An output port of the first coupled transmission line may be coupled to the RF-output of the RF-circuit.

According to various embodiments, the transmission line coupled structure has a self-resonant frequency smaller than an operating frequency of a signal at the RF-output of the RF-circuit.

As used herein and in accordance with various embodiments, an operating frequency may be defined as the frequency for which the integrated RF-circuit is designed to operate, for example a center of an operating frequency band.

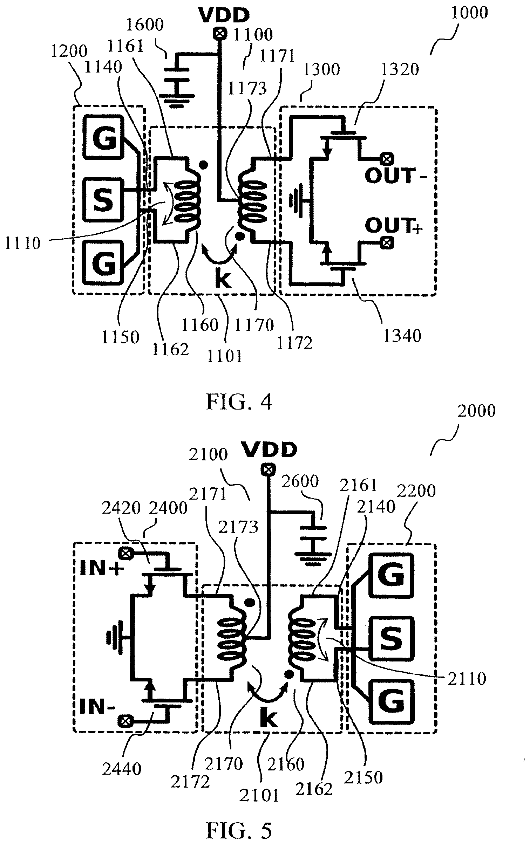

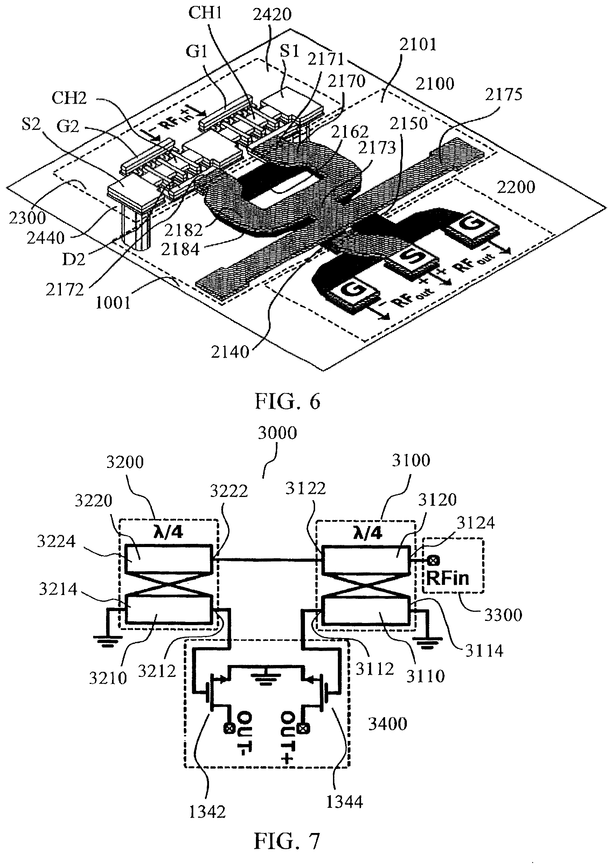

In the following, exemplary embodiments will be showed using the figures for illustration purposes. For ease of understanding, FIGS. 4-6 are drawn such that the RF-signal flows from the left side to the right side. In each case, the RF-circuit is shown as coupled to the second terminal that is at the second side of the coupled structure. In case of FIG. 4, the RF-signal direction is shown from the primary winding of the transformer to the circuit-side winding, and in the case of FIGS. 5 and 6, from the circuit-side winding to the secondary winding.

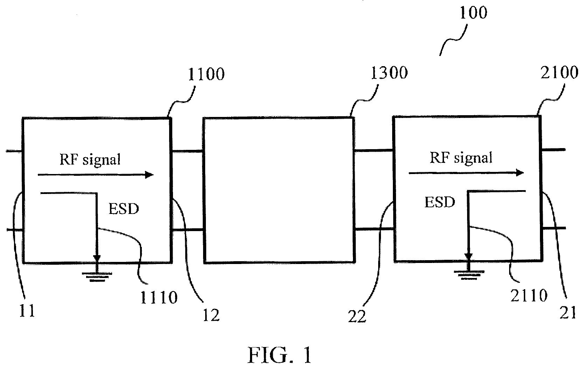

FIG. 1 shows a schematic illustration of an integrated RF-circuit 100. The integrated RF-circuit 100 includes a substrate of a II/V semiconductor material. The integrated RF-circuit 100 further includes an RF-circuit 1300 formed on the substrate and including at least one transistor, an RF-input, and an RF-output.

At least one coupled structure 1100, 2100 formed on the substrate, including a first side and a second side galvanically separated from each other, and configured to convey an RF signal between a first connection terminal of the first side and a second terminal of the second side. The coupled structure 1100 has a first side 11 including a first connection terminal and a second side 12 including a second terminal. The first connection terminal may receive RF-signal. The second terminal may be coupled to the RF-input of the RF-circuit 1300 and transmit coupled RF-signal to the RF-circuit 1300. The first side may include a low impedance path 1110 to a voltage connector of the integrated RF circuit 100 for flow of electrostatic discharge, for example to ground. The ground may be the DC-ground connection.

The coupled structure 1100 has a first side 21 including a first connection terminal and a second side 22 including a second terminal. The second terminal may be coupled to the RF-output of the RF-circuit 1300 and receive RF-signal from the RF-circuit 1300. The first side may include a low impedance path 1110 to a voltage connector of the integrated RF circuit 100 for flow of electrostatic discharge, for example to ground. The ground may be the DC-ground connection.

FIG. 1 shows two coupled structures 1100, 2100 coupled to the RF-circuit 130Q, however the present disclosure is not limited thereto, the integrated RF-circuit may include one coupled structure, or two or more coupled structures.

The at least one coupled structure may be implemented in III/V technology. For example, it may mean that the coupled structure(s) may be implemented with the same processes available for II/V semiconductors, without requiring other semiconductor technologies, for example without necessarily requiring silicon CMOS technology. Compared to II/V integrated RF-circuit without ESD protection, present embodiments describe integrated RF-circuits that are improved to provide ESD protection, without necessarily requiring the addition of dedicated ESD structure (e.g. as a separate component on its own substrate or as a separate device). This improvement provided by the coupled structures which may be manufacture by the same II/V manufacturing processes, and no external ESD component (e.g. no external component having a p-n junction or a p-i-n junction) needs to be added for the ESD protection.

The at least one coupled structure may be provided with a circuit topology that does not require any special ESD diode, transistor, or thyristor structure and it thus has advantages for implementation in III/V. p-n or p-i-n junction provided with II/V semiconductors are of complex manufacturing and it was found that p-n junctions alone may not be suitable for ESD protection and/or may affect the circuit's performance. Furthermore, the at least one coupled structure offers a compact and broadband matching structure in III/V technology.

Various embodiments may include an additional ESD protection. The additional ESD protection may include an ESD discharging connection to a voltage connector of the integrated RF circuit, for example to ground. The ground may be the DC-ground connection. The ESD discharging connection may be via a conductor or may include an ESD component, for example, including diodes. In one example, the ESD component may include a reverse polarized diode in parallel with a series connection of two (or more) forward polarized diodes. Due to the position of the ESD discharging connection, for example at a center tap of the primary winding, an ESD component, such as a pn junction (for example made in III/V technology) does not substantially affect the impedance of the coupled structure and does not substantially affect the performance of the RF-circuit. An additional ESD protection may be applied to a primary winding opposite to a circuit-side winding, or to a secondary winding opposite to a circuit-side winding, depending on the required coupling between the coupled structure and the RF-circuit.

According to various embodiments, the integrated RF-circuit may include one or more coupled structures. For example the RF-circuit may include signal terminals, for example first and second signal terminals, these may be called herein RF-input, and RF-output, however they may also be bi-directional. A first coupled structure may be coupled to the first signal terminal and a second coupled structure may be coupled to the second signal terminal. The first and second coupled structure may each include or be a transformer. Alternatively, the first and second coupled structure may each include or be a coupled-transmission line. In yet another alternative, the first coupled structure may include or be a transformer and the second coupled structure may include or be a coupled-transmission line, or vice-versa. It was found that transformers and coupled-transmission lines can be easily implemented in existing II/V technologies.

The coupled structure(s) transfers signals at an RF frequency, for example at a pre-determined operating frequency of the integrated RF-circuit. The coupled structure may provide an isolation for ESD events, since these events typically occur at different frequencies. Further, the coupled structure(s) provide galvanic isolation between the RF-circuit and connection terminals. The coupled structure(s) may be implemented at the signal terminal(s) of the RF-circuit. This creates a leakage path for the ESD events that may occur at these signal terminals. This leakage path prevents the harmful ESD pulses to arrive at transistor terminals of the RF-circuit. Thus, the coupled structure(s) may be implemented at the signal terminal(s) (e.g. input and output) as an integral portion of the integrated RF-circuit. Exemplary coupled structures are transformers and coupled transmission lines, which will be explained in further details below.

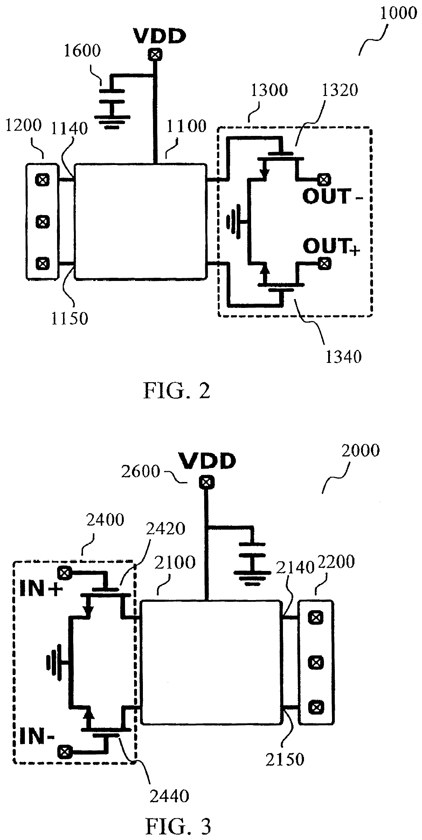

FIG. 2 shows a schematic illustration of an integrated RF-circuit 1000 (or of a partial illustration of an integrated RF-circuit 1000 as it may include more components) including a coupled structure 1100 coupling a terminal 1200 to an RF-circuit 1300. The coupled structure may include or be a transformer or a coupled transmission line. The RF-circuit 1300 is shown as a differential amplifier including a first transistor 1320 and a second transistor 1340. The integrated RF-circuit 1000 receives signal at terminal 1200 which is coupled by the coupled structure 1100 to the respective gates of transistors 1320 and 1340 of the RF-circuit 1300 and provided, by the transistors, as output (OUT+, OUT-), for example to another circuit. The RF-circuit is represented by the differential amplifier for illustration purposes, however the RF-circuit may have other configurations, as required by the desired RF application. For example, the RF-circuit may include one transistor, or may include more than two transistors implemented in II/V technology. The coupled structure 1100 provides the galvanic isolation between terminal 1200 and RF-circuit 1300, and a low impedance path 1110 for discharge of an ESD event.

FIG. 3 shows a schematic illustration of an integrated RF-circuit 2000 (or of a partial illustration of an integrated RF-circuit 1000) including a coupled structure 2100 coupling a terminal 2200 to an RF-circuit 2400. The coupled structure may include or be a transformer or a coupled transmission line. The RF-circuit 2400 is shown as a differential amplifier including a first transistor 2420 and a second transistor 2440. The integrated RF-circuit 2000 receives signal at the transistor terminals (IN+, IN-) which is amplified and coupled by the coupled structure 2100 to the terminal 2200, for example to a connector. The RF-circuit is represented by the differential amplifier for illustration purposes, however the RF-circuit may have other configurations, as required by the desired RF application. For example, the RF-circuit may include one transistor, or may include more than two transistors implemented in II/V technology. The coupled structure 2100 provides the galvanic isolation between RF-circuit 2400 and terminal 2200, and a low impedance path 2110 for discharge of an ESD event.

FIG. 4 shows a block diagram of an integrated RF-circuit 1000, including a terminal 1200, a coupled structure 1100, and an RF-circuit 1300. An exemplary terminal may include I/O pins, for example a signal pin S and one or more pins G, for example 2 pins G symmetrically disposed on opposite sides of pin G. Pins "G", in accordance with various embodiments, herein may refer in each case, to a floating AC ground. In embodiments, "G" may be connected to the DC ground, for example off-chip. The coupled structure 1100 includes a first side coupled to the terminal 1200 and a second side coupled to the circuit 1300, for transmission of signal. The first side of the at least one coupled structure may be implemented as , an input side. The at least one coupled structure 1100 may be a transformer 1101 with a primary winding 1162 on the first side and a circuit-side winding 1170 on the second side. An output of the circuit-side winding 1170 may be coupled to the RF-input of the RF-circuit 1300. The RF-circuit 1300 is identical to previously described RF-circuit in FIG. 2, for illustration purposes. Thus, in some embodiments, an RF signal may flow from the terminal 1200, through the coupled structure 1100 to the RF-circuit 1300. The integrated RF-circuit may also be configured to allow bi-directional flow of RF-signal.

In FIG. 4, the coupled structure is implemented as a transformer 1101 including a primary winding and a circuit-side winding. According to various embodiments, the circuit-side winding 1170 and the primary winding 1162 are formed as at least partially parallel conductors, wherein each of the conductors may be disposed in a respective metal pattern layer, and optionally wherein the conductors are ring shaped. The coupled structure couples signal between the terminal 1200 and the RF-circuit 1300. The coupled structure 1100 has a low-loss for the RF signal to be coupled to and from the RF-circuit. Also, the coupled structure 1100 protects the active RF-circuits from an ESD event at the terminal 1200. The coupled structure 1100 provides a low impedance path to ground, through which the ESD pulse can flow. This flow of current is not coupled through the coupled structure to the input of output of the RF circuit. According to various embodiments, the circuit-side winding 1160 of the transformer 1101 may further include a biasing connection 1173 between the ends of the circuit-side winding 1170 (e.g., a center tap), wherein the biasing connection 1173 may be coupled, e.g. via a bias line, to a voltage connector of the integrated RF-circuit, for example to VDD. Decoupling capacitor(s) 1600 may also be provided for the bias line. Capacitor(s) and/or inductor(s) may be optionally added at the first side and/or at the second side of the coupled structures, for impedance matching purposes.

According to various embodiments, and as illustrated in FIG. 4, the at least one transistor may include a first transistor 1320 electrically connected with an end of the circuit-side winding 1170 of the transformer 1101. The first transistor 1320 may include a II/V semiconductor structure, for example the first transistor 1320 may be a FET including a channel of a III/V semiconductor, e.g., of GaAs or InP. According to some embodiments, and as illustrated in FIG. 4, the RF-circuit 1300 may include a differential amplifier including the first transistor 1320 and a second transistor 1340. A respective control terminal of the first and second transistors 1320, 1340 may be constituting the RF-input and a further RF-input, each coupled to a corresponding end of the circuit-side winding 1170 of the transformer 1101. Exemplary control terminals are gate of FETs.

According to various embodiments, the transformer 1101 may have a self-resonant frequency smaller than an operating frequency of a signal at the RF-input of the RF-circuit 1300.

FIG. 5 shows a block diagram of an integrated RF-circuit 2000, including an RF-circuit 2400, a coupled structure 2100, and a terminal 2200. An exemplary terminal may include I/O pins, for example a signal pin S and one or more pins G, for example 2 pins G symmetrically disposed on opposite sides of pin G. The terminal 2200 is coupled to the coupled structure 2100 for transmission of signal, for example for receiving signal from the couples structure and output the signal at the terminal. The coupled structure 2100 includes a first side coupled to the terminal 2200 and a second side coupled to the circuit 2300, for transmission of signal. The first side of the coupled structure 2100 may be implemented as an output side. The at least one coupled structure 2100 may be a transformer 2101 with a secondary winding 2162 on the first side and a circuit-side winding 2170 on the second side. The RF-input of the RF-circuit 2400 may be coupled to an input of the circuit-side winding 2170. The RF-circuit 2400 is identical to previously described RF-circuit in FIG. 3, for illustration purposes. Thus, in some embodiments, an RF-signal may flow from the RF-circuit 2400, through the coupled structure 2100 to the terminal 2200. The integrated RF-circuit may also be configured to allow bi-directional flow of RF-signal.

In FIG. 5, the coupled structure is implemented as a transformer 2101 including a secondary winding and a circuit-side winding. According to various embodiments, the circuit-side winding 2170 and the secondary winding 2162 are formed as at least partially parallel conductors, wherein each of the conductors may be disposed in a respective metal pattern layer, and optionally wherein the conductors are ring shaped. The coupled structure couples signal between the terminal 2200 and the RF-circuit 2400. The coupled structure 2100 has a low-loss for the RF signal to be coupled to and from the RF-circuit. Also, the coupled structure 2100 protects the active RF-circuits from an ESD event at the terminal 2200. The coupled structure 2100 provides a low impedance path to ground, through which the ESD pulse can flow. This flow of current is not coupled through the coupled structure to the input or output of the RF circuit. According to various embodiments, the circuit-side winding 2160 of the transformer 2101 may further include a biasing connection 2173 between the ends of the circuit-side winding 2170 (e.g., a center tap), wherein the biasing connection 2173 may be coupled, e.g. via a bias line, toa voltage connector of the integrated RF-circuit, for example to VDD. Decoupling capacitor(s) 2600 may also be provided for the bias line. Capacitor(s) and/or inductor(s) may be optionally added at the first side and/or at the second side of the coupled structures, for impedance matching purposes.

According to various embodiments, and as illustrated in FIG. 5, the at least one transistor may include a first transistor 2420 electrically connected with an end of the circuit-side winding 2170 of the transformer 2101. The first transistor 2420 may include a III/V semiconductor structure, for example the first transistor 2420 may be a FET including a channel of a III/V semiconductor, e.g., of GaAs or InP. According to some embodiments, and as illustrated in FIG. 5, the RF-circuit 2400 may include a differential amplifier including the first transistor 2420 and a second transistor 2440. A respective control terminal of the first and second transistors 2420, 2440 may be constituting the RF-input and a further RF-input. One of the other terminals of each of the transistors (e.g., source or drain) may be coupled to a corresponding end of the circuit-side winding 2170 of the transformer 2101. Exemplary control terminals are gate of FETs.

According to various embodiments, the transformer 2101 may have a self-resonant frequency smaller than an operating frequency of a signal at the RF-input of the RF-circuit 2400.

FIG. 6 shows an exemplary layout of an integrated RF-circuit including a transformer 2101 as coupled structure 2100 coupled to connection terminal 2200 on the first side and to the RF-circuit 2300 on the second side.

The coupled structure of FIG. 6 includes a transformer. The transformer may include a circuit-side winding 2170 and a secondary winding 2162. The circuit-side winding 2170 and the secondary winding 2162 may be formed as at least partially parallel conductors. Each of the at least partially parallel conductors may be disposed in a respective metal pattern layer, e.g. as stacked layers separated by a dielectric layer (not shown).

In FIG. 6, the input of the circuit-side winding 2170 is coupled to the RF-output of the RF-circuit 1300. Thus, the transformer receives RF-signal from the RF-circuit 1300 and couples the RF-signal via the circuit-side winding 2170 and the secondary winding 2162 to the connection terminal 2200. The connection terminal 2200 is represented by a pad S and two pads G, and the signal (RFout) may be obtained from the S and any of the G terminals.

The integrated circuit of FIG. 6 includes a substrate 1001. The substrate may be a III/V semiconductor substrate, for example GaAs or InP. The RF-circuit 2300 may be provided on the substrate and/or be at least partially embedded in the substrate, for example portions of the substrate may provide transistor structures, e.g., transistor channel(s). The coupled structure 2100 and the connection terminal 2200 may be provided on the substrate, for example, disposed in the form of patterned layers on the substrate.

The RF-circuit 2300 may include a first transistor 2420 and a second transistor 2440. The first transistor 2420 may include a gate G1 for receiving RF signal, for example from another portion of the RF-circuit or from external to the RF-circuit. The first transistor may further include a drain D1 which may be coupled to one input 2171 of the circuit-side winding 2170 of the transformer 2101 and a source S1 which may be coupled to ground. The ground may be the DC-ground connection. The second transistor may further include a drain D2 which may be coupled to one input 2172 of the circuit-side winding 2170 of the transformer 2101 and a source S2 which may be coupled to ground. The ground may be the DC-ground connection.

The circuit-side winding 2170, may include inputs 2171 and 2172 and may be in the form of a partial ring (or U-shaped) layer structure. The circuit-side winding 2170 may further include a center tap 2175 for example for connecting to VDD providing the biasing connection 1173 and/or to ground via a capacitor. The circuit-side winding 2170 may overlap, for example partially overlap, the secondary winding 2162. The secondary winding may include outputs 2140 and 2150, and may be in the form of a partial ring (or U-shaped) layer structure. In the example of FIG. 6, the output 2140 is coupled to the layer of the pad S, e.g. through a via. The output 2150 extends continuously through the pads G. It is understood that the layer configurations are for illustration purposes and may be implemented differently as illustrated in FIG. 6. As shown, both the circuit-side winding 2170 and the secondary winding 2162 may be formed of patterns (2182, 2184) of patterned metal layers and may be separated by a dielectric layer.

FIG. 7 shows a schematic illustration of a transmission line coupled structure 3000 coupling an RF-circuit 3400 to an RF terminal (RFin) 3300, in accordance with various embodiments. The transmission line coupled structure may include a first side and a second side. The first side may be an input side of the at least one coupled structure 3000 and may include RF-outputs 3112 and 3212. The transmission line coupled structure 3000 may include a first quarter wave coupler 3100 and a second quarter wave coupler 3200. The first quarter wave coupler 3100 may include a first direct transmission line 3110 and a first coupled transmission line 3120. An output port of the first coupled transmission line 3212 may be coupled to the RF-input of the RF-circuit 1300. Further, the second quarter wave coupler 3200 may include a first direct transmission line 3210 and a first coupled transmission line 3220. An output port of the second coupled transmission line 3212 may be coupled to the RF-input of the RF-circuit 1300. For example, the RF-outputs 3112 and 3121 may each be coupled to a respective control terminal (e.g. a gate) of the transistors 1320 and 1340.

According to various embodiments, the transmission line coupled structure 3000 may have a self-resonant frequency smaller than an operating frequency of a signal at the RF-input of the RF-circuit 1300. Capacitors or inductors may be further added to the input or output of the transmission line coupled structure for matching purposes.

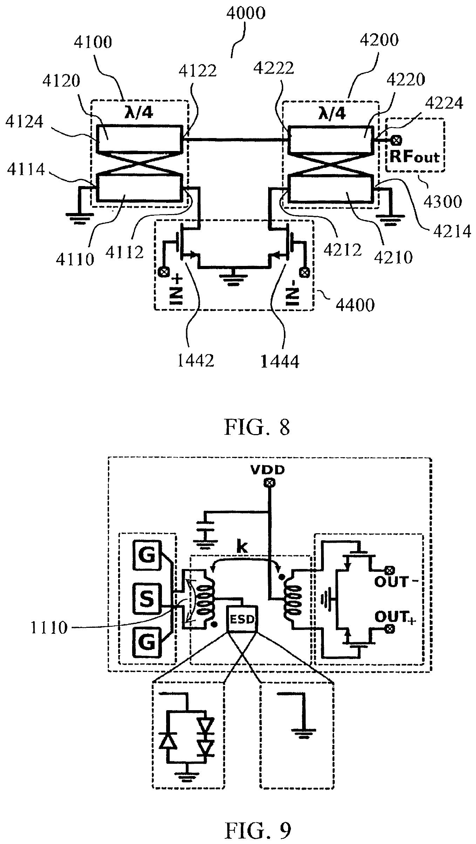

FIG. 8 shows a schematic illustration of a transmission line coupled structure 4000 coupling an RF-circuit 4400 to an RF terminal (RFout) 4300, in accordance with various embodiments. The transmission line coupled structure may include a first side and a second side. The first side may be an input side of the at least one coupled structure 4000 and may include RF-inputs 4112 and 4212 for receiving RF-signal from the RF-circuit 4400. The transmission line coupled structure 4000 may include a first quarter wave coupler 4100 and a second quarter wave coupler 4200. The first quarter wave coupler 4100 may include a first direct transmission line 4110 and a first coupled transmission line 4120. An RF-input 4112 of the first coupled transmission line may be coupled to the RF-input of the RF-circuit 1300. Further, the second quarter wave coupler 4200 may include a first direct transmission line 4210 and a first coupled transmission line 4220. An input port 4212 of the second coupled transmission line 4212 may be coupled to the RF-input of the RF-circuit 1300. For example, the RF-inputs 4112 and 4121 may each be coupled to a respective control terminal (e.g. a gate) of the transistors 1442 and 1444. An output 4224 of the first or second quarter wave couplers may be coupled to an RF-output RFout terminal.

According to various embodiments, the transmission line coupled structure 4000 may have a self-resonant frequency smaller than an operating frequency of a signal at the RF-output of the RF-circuit 4400. Capacitors or inductors may be further added to the input or output of the transmission line coupled structure for matching purposes.

Without being bound to theory, the self-resonant frequency of an inductor is the frequency at which the parasitic capacitance of the inductor resonates with the ideal inductance of the inductor resulting in an extremely high impedance. At this frequency the inductor may look like an open circuit. When using a transformer, for example as in a coupled structure, a self-resonance frequency may also be defined for the transformer. At this self-resonance frequency, the input impedance of the transformer may be infinitely high. If the transformer is operated below its self-resonance frequency, the input impedance of the transformer is inductive. However, when the operating frequency is well above the self-resonance frequency, the input impedance of the transformer becomes capacitive. According to various embodiments using a transformer in the coupled structure, a transformer that is operating above its self-resonance frequency may have advantages. For example, if the self-resonant frequency at the circuit-side winding is smaller than a center of an operating frequency of a signal of the RF-circuit (such as nominal operating frequency of the integrated RF-circuit) the circuit-side winding may have an output and/or input which is capacitive. It was surprisingly found that this enables a signal gain which is attributed to an inductive impedance of the RF-circuit, and a cancelling out between the inductive impedance of the RF-circuit and the capacitive impedance of the transformer.

FIG. 9 shows a further development of various embodiments. FIG. 9 shows a schematic illustration of a transformer as coupled structure including an additional ESD protection for the first side, in the form of an ESD discharging connection between the ends of the primary winding. The transformer is shown integrated in the integrated RF-circuit, and is identical to the transformer shown in

FIG. 4, except that in FIG. 9, the first side includes the additional ESD connection, including a discharge path to a voltage connector of the integrated RF-circuit 100 for flow of electrostatic discharge. The additional ESD discharging connection may be between the terminals of the primary winding.

According to various embodiments, the additional ESD protection may include an ESD discharging connection to a voltage connector of the integrated RF circuit, for example to ground. The ground may be the DC-ground connection. The ESD discharging connection may be via a conductor or may include an ESD component, for example, including diodes. In one example, the ESD component includes a reverse polarized diode in parallel with a series connection of two (or more) forward polarized diodes. Due to the position of the ESD discharging connection, for example at a center tap of the primary winding, an ESD component, such as a pn junction (for example made in III/V technology) does not substantially affect the impedance of the coupled structure and does not substantially affect the performance of the RF-circuit.

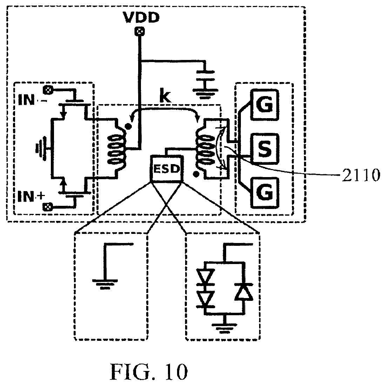

FIG. 10 shows a further development of various embodiments. FIG. 9 shows schematic illustration of a transformer as coupled structure including an additional ESD protection for the first side, in the form of an ESD discharging connection between the ends of the secondary winding. The transformer is shown integrated in the integrated RF-circuit, and is identical to the transformer shown in FIG. 5, except that in FIG. 10, the first side includes the additional ESD connection, including a discharge path to a voltage connection of the integrated RF-circuit 100 for flow of electrostatic discharge. The additional ESD discharging connection may be between the terminals of the secondary winding.

According to various embodiments, the additional ESD protection may include a connection from an ESD discharging connection to ground. The ground may be the DC-ground connection. The ESD discharging connection may be via a conductor or may include an ESD component, for example, including diodes. In one example, the ESD component includes a reverse polarized diode in parallel with a series connection of two (or more) forward polarized diodes. Due to the position of the ESD discharging connection, for example at a center tap of the secondary winding, an ESD component, such as a pn junction (for example made in III/V technology) does not substantially affect the impedance of the coupled structure and does not substantially affect the performance of the RF-circuit.

Various embodiments related to an electronic device including a communication module including an integrated RF-circuit. The electronic device may further include an antenna coupled to the RF-input or the RF-output of the RF-circuit.

The integrated RF-circuit may applied on, for example be part of, electronic devices requiring RF communication such as RF front-end circuits for radar, RF front end-circuits for communication, or 5G circuits. The integrated RF-circuit may also applied on, for example be part of an LNA, a mixer, or a phase shifter.

Exemplary electronic devices including the integrated RF-circuit may be selected from: automotive telecommunication-network connected devices, high data rate systems, wireless power transfer devices, electronic interfaces for optical communication systems, mobile phone, cellular infrastructure devices, satellite communication device, radar device, or combinations thereof.

## Claims

1. An integrated RF-circuit (100) with ESD protection comprising
a substrate (1001) of a III/V semiconductor material,
an RF-circuit (1300) formed on the substrate and comprising at least one transistor, an RF-input, and an RF-output;
at least one coupled structure (1100, 2100, 3100, 4100) formed on the substrate (1001), including a first side and a second side galvanically separated from each other, and configured to convey an RF signal between a first connection terminal of the first side and a second terminal of the second side,
wherein the second terminal is connected to the RF-input or the RF-output of the RF-circuit (1300), and
wherein the first side comprises a low impedance path (1110) to a voltage connector of the integrated RF-circuit (100) for flow of electrostatic discharge.

2. The integrated RF-circuit (100) of claim 1,
wherein the first side is an input side of the at least one coupled structure (1100),
wherein the at least one coupled structure (1100) is a transformer (1101) with a primary winding (1162) on the first side and a circuit-side winding (1170) on the second side, and
wherein an output of the circuit-side winding (1170) is coupled to the RF-input of the RF-circuit (1300).

3. The integrated RF-circuit (100) of claim 2, wherein the at least one transistor comprises a first transistor (1320) electrically connected with an end of the circuit-side winding (1170) of the transformer (1101), and wherein the first transistor (1320) comprises a III/V semiconductor structure, and optionally, wherein the RF-circuit (1300) comprises a differential amplifier including the first transistor (1320) and a second transistor (1320, 1340), and wherein a respective control terminal of the first and second transistors (1320, 1340) is constituting the RF-input and a further RF-input, each coupled to a corresponding end of the circuit-side winding (1170) of the transformer (1101).

4. The integrated RF-circuit (100) of claim 3, wherein the circuit-side winding (1170) and the primary winding (1162) are formed as at least partially parallel conductors, wherein each of the conductors is disposed in a respective metal pattern layer, and/or
wherein the circuit-side winding (1160) of the transformer (1101) further comprises a biasing connection (1173) between the ends of the circuit-side winding (1170),
wherein the biasing connection (1173) is coupled to the low impedance path (1110).

5. The integrated RF-circuit (100) of claim 3 or claim 4, wherein the transformer (1101) has a self-resonant frequency smaller than an operating frequency of a signal at the RF-input of the RF-circuit (1300).

6. The integrated RF-circuit (100) of any one of claims 2 to 5, further comprising an ESD discharging connection between the ends of the primary winding (1162), optionally, further comprising an ESD protection component.

7. The integrated RF-circuit (100) of claim 1,
wherein the first side is an output side of the at least one coupled structure (2100),
wherein the at least one coupled structure (2100) is a transformer (2101) with a secondary winding (2162) on the first side and a circuit-side winding (2170) on the second side,
wherein an input of the circuit-side winding (2170) is coupled to the RF-output of the RF-circuit (2400), and optionally comprising an ESD discharging connection between the ends of the secondary winding (1162), further optionally, comprising an ESD protection component.

8. The integrated RF-circuit (100) of claim 7, wherein the at least one transistor comprises a first transistor (2320) electrically connected with an end of the circuit-side winding (2170) of the transformer (2101), and wherein the first transistor (2320) comprises a III/V semiconductor structure, and optionally, wherein the RF-circuit (2300) comprises a differential amplifier including the first transistor (2420) and a second transistor (2440), and wherein a respective control terminal of the first and second transistors (2420, 2440) is constituting the RF-output and a further RF-output, each coupled to a corresponding end of the circuit-side winding (2170) of the transformer (2101).

9. The integrated RF-circuit (100) of claim 8, wherein the circuit-side winding (2170) an the secondary winding (2162) are formed as at least partially parallel conductors, wherein each of the conductors is disposed in a respective metal pattern layer, and/or
wherein the circuit-side winding (2170) of the transformer further comprises a biasing connection (2173) between the ends of the circuit-side winding (2170),
wherein the biasing connection (2173) is coupled to the low impedance path (2110).

10. The integrated RF-circuit (100) of any one of claims 7 to 9, wherein the transformer (2101) has a self-resonant frequency smaller than an operating frequency of a signal at the RF-output of the RF-circuit (2300).

11. The integrated RF-circuit (100) of claim 1,
wherein the first side is an input side of the at least one coupled structure (3000, 4000),
wherein the at least one coupled structure is a transmission line coupled structure (3000), and optionally:
wherein the transmission line coupled structure (3000) comprises a first quarter wave coupler (3100) and a second quarter wave coupler (3200),
wherein the first quarter wave coupler (3100) comprises a first direct transmission line (3110) and a first coupled transmission line (3120),
wherein an output port of the first coupled transmission line (3124) is coupled to the RF-input of the RF-circuit (1300).

12. The integrated RF-circuit (100) of claim 11, wherein the transmission line coupled structure (3000) has a self-resonant frequency smaller than an operating frequency of a signal at the RF-input of the RF-circuit (1300).

13. The integrated RF-circuit (100) of claim 1,
wherein the first side is an output side of the at least one coupled structure (3000, 4000),
wherein the at least one coupled structure is a transmission line coupled structure (4000), and optionally:
wherein the transmission line coupled structure (4000) comprises a first quarter wave coupler (4100) and a second quarter wave coupler (4200),
wherein the first quarter wave coupler (4100) comprises a first direct transmission line (4110) and a first coupled transmission line (4120),
wherein an output port of the first coupled transmission line (4124) is coupled to the RF-output of the RF-circuit (2400).

14. The integrated RF-circuit (100) of claim 13, wherein the transmission line coupled structure (4000) has a self-resonant frequency smaller than an operating frequency of a signal at the RF-output of the RF-circuit (2400).

15. An electronic device comprising:
a communication module comprising an integrated RF-circuit (100) according to any one of the previous claims,
an antenna coupled to the RF-input or to the RF-output of the RF-circuit (100), and optionally, the electronic device being one of: a mobile phone, a satellite communication device, a radar device.
